# EUROPÄISCHE PATENTSCHRIFT

(11) **EP 3 571 033 B1**
(45) Veröffentlichungstag und Bekanntmachung des Hinweises auf die Patenterteilung: **23.12.2020**
(21) Anmeldenummer: 17701995.7
(22) Anmeldetag: 19.01.2017
(51) Int. Cl.: B29C 45/14

(54) **VERFAHREN ZUM HERSTELLEN EINES EMV-ABSCHIRMGEHÄUSES UND EMV-ABSCHIRMGEHÄUSE**
PROCESS FOR MANUFACTURING AN EM-RADIATION SHIELDED HOUSING ET SUCH AN EM-RADIATION SHIELDED HOUSING
PROCÉDÉ DE LA FABRICATION D'UNE

(43) Veröffentlichungstag der Anmeldung: 27.11.2019
(73) Patentinhaber: Diehl AKO Stiftung & Co. KG, 88239 Wangen (DE)
(72) Erfinder: HEINLE, Christoph, 87480 Weitnau (DE)
(74) Vertreter: Diehl Patentabteilung
(86) Internationale Anmeldenummer: PCT/EP2017/000060
(87) Internationale Veröffentlichungsnummer: WO 2018/133911

(56) Entgegenhaltungen:
- EP-A1- 2 427 038
- DE-A1- 19 528 731
- DE-A1-102009 001 373
- DE-A1-102010 064 351
- DE-A1-102014 202 393
- US-A1- 2002 180 108

## Beschreibung

Die vorliegende Erfindung betrifft ein Verfahren zum Herstellen eines EMV-Abschirmgehäuses für eine Elektronik.

EMV-Abschirmgehäuse dienen zur Sicherung der elektromagnetischen Verträglichkeit (EMV) elektronischer Geräte, d.h. zur Reduzierung der elektromagnetischen Abstrahlung elektronischer Geräte und zum Schutz elektronischer Geräte gegen elektromagnetische Einstrahlung. Zu den elektronischen Geräten, die eine solche EMV-Abschirmung benötigen, zählen zum Beispiel Elektromotoren, Antriebselemente, Steuergeräte, etc. zum Beispiel in elektronischen Haushaltsgeräten.

Es ist bekannt, eine elektromagnetische Abschirmung durch ein Metallgehäuse zu erzielen. Insbesondere aus Gewichts- und Preisgründen werden aber häufig Kunststoffgehäuse bevorzugt. Um ein EMV-wirksames Kunststoffgehäuse zu erzeugen, ist es zum Beispiel bekannt, das Kunststoffgehäuse mit einer EMV-wirksamen Beschichtung (metallisches Bedampfen, Leitlack, etc.) zu versehen oder elektrisch leitfähige Kunststoffe für das Gehäuse zu verwenden.

Ferner ist es zum Beispiel aus DE 10 2010 064 351 A1, EP 2 427 038 A1 und US 2002/0180108 A1 bekannt, eine elektromagnetische Abschirmung durch ein Kunststoffgehäuse mit einem integrierten EMV-wirksamen Gewebe oder Metallnetz zu erzeugen. Zur Herstellung eines solchen EMV-Abschirmgehäuses wird beispielsweise das EMV-wirksame Gewebe in Form eines Prepregs in ein Spritzgießwerkzeug eingelegt und wird dann eine Kunststoffkomponente aus einem Thermoplasten eingespritzt (z.B. EP 2 427 038 A1). Außerdem kann ein thermoplastisches Kunststoffhalbzeug zur Abschirmung von elektromagnetischer Strahlung ein Verstärkungsmaterial aus Verstärkungsfasern oder -textil und leitfähige Fasern, Faserabschnitte oder -textil aufweisen, die mit einer thermoplastischen Matrix imprägniert sind (z.B. DE 10 2014 202 393 A1). Die DE 10 2009 001 373 A1 beschreibt ein elektrisches Schaltungsmodul mit einer elektrischen Baugruppe, die in einen elektrisch nicht-leitenden Kunststoff-Formkörper eingebettet ist, in dem sich ein Formkörperträger aus Metall zur elektrischen Abschirmung befindet. Die DE 195 28 731 A1 offenbart ein Verfahren zum Schützen von elektrischen Bauteilen, bei dem die Bauteile unter Verwendung eines Spritzgießverfahrens mit einer Vergussmasse aus thermoplastischen Kunststoff ummantelt werden, in der zur EMV-Abschirmung auch leitfähige Partikel vorgesehen sein können.

Der Erfindung liegt die Aufgabe zugrunde, einen einfachen Fertigungsprozess zur Herstellung eines EMV-Abschirmgehäuses aus Kunststoff für eine Elektronik zu schaffen.

Diese Aufgabe wird gelöst durch das Verfahren gemäß Anspruch 1. Besonders vorteilhafte Ausgestaltungen und Weiterbildungen der Erfindung sind Gegenstand der abhängigen Ansprüche.

Das erfindungsgemäße Verfahren zum Herstellen eines EMV-Abschirmgehäuses enthält die Schritte des Einlegens der Elektronik in ein Formwerkzeug; des Einlegens eines EMV-wirksamen Gewebes in Form eines Prepregs 22, d.h. eines mit einem Kunststoffmaterial durchtränkten Gewebes, in das Formwerkzeug derart, dass das EMV-wirksame Gewebe die Elektronik mit einem Abstand zu dieser umschließt; des Einspritzens einer Kunststoffkomponente zum Bilden einer Vergussmasse zum Kapseln der Elektronik in das Formwerkzeug, wobei die Kunststoffkomponente für die Vergussmasse das EMV-wirksame Gewebe zumindest teilweise durchdringt; des Einspritzens einer ersten Kunststoffkomponente zum Bilden eines Kunststoff-Formteils des EMV-Abschirmgehäuses angrenzend an das EMV-wirksame Gewebe und die Kunststoffkomponente für die Vergussmasse in das Formwerkzeug; und des Einspritzens einer zweiten Kunststoffkomponente für das Kunststoff-Formteil des EMV-Abschirmgehäuses angrenzend an die erste Kunststoffkomponente für das Kunststoff-Formteil des EMV-Abschirmgehäuses in das Formwerkzeug.

Mit diesem Verfahren kann auf einfache Weise ein Kunststoffgehäuse hergestellt werden, das EMV-abschirmende Eigenschaften besitzt. Durch die Integration des EMV-wirksamen Gewebes während des Formungsprozesses werden keine zusätzlichen Verfahrensschritte benötigt, um ein Kunststoffgehäuse anschließend mit EMV-Abschirmeigenschaften zu versehen. Die Verwendung eines EMV-abschirmenden Gewebes schränkt die Formgebungsmöglichkeiten für das Abschirmgehäuse zudem nicht ein. Außerdem kann mit diesem Verfahren die Elektronik in einem einzigen Fertigungsschritt mit mehreren sequenziell oder parallel ausgeführten Spritzgießprozessen in einem Formwerkzeug in das EMV-Abschirmgehäuse integriert werden.

Bei dem Abschirmgehäuse kann es sich in diesem Fall um ein Gehäuse handeln, welches ein oder mehrere Elektronikkomponenten ganz oder teilweise umgibt. Das Gehäuse kann geschlossen sein oder ein oder mehrere Gehäuseöffnungen aufweisen. Das Abschirmgehäuse kann je nach Anwendungsfall verschiedene weitere spezielle Eigenschaften aufweisen, wie zum Beispiel Wärmeleitfähigkeit, zumindest teilweise Transparenz, und dergleichen.

Bei dem Formwerkzeug handelt es sich in diesem Zusammenhang um ein grundsätzlich beliebiges Formwerkzeug, das für ein Spritzgießverfahren geeignet ist. Das Formwerkzeug kann insbesondere ein oder mehrere Kavitäten aufweisen, ein oder mehrere Einspritzdüsen aufweisen, mit ein oder mehreren bewegbaren Teilen versehen sein, und dergleichen.

Bei den Kunststoffkomponenten handelt es sich jeweils grundsätzlich um ein beliebiges Kunststoffmaterial, das zur Verarbeitung in einem Spritzgießverfahren geeignet ist. Die ersten und zweiten Kunststoffkomponenten für das Kunststoff-Formteil können aus dem gleichen Kunststoffmaterial oder aus unterschiedlichen Kunststoffmaterialien bestehen. Vorzugsweise ist die Kunststoffkomponente für die Vergussmasse elektrisch nicht-leitend. Vorzugsweise weisen die Kunststoffkomponente für die Vergussmasse und die erste Kunststoffkomponente für das Formteil jeweils ein wärmeleitendes Kunststoffmaterial auf.

Bei dem EMV-wirksamen Gewebe handelt es sich grundsätzlich um ein beliebiges Gewebe, welches elektromagnetische Strahlung abschirmen kann. Die Abschirmwirkung kann insbesondere durch die Materialeigenschaften und die Konfiguration des Gewebes erzielt werden. Das Gewebe kann vorzugsweise aus Metall-, Kunststoff- und/oder Textilfäden gebildet sein. Der Begriff "Gewebe" soll in diesem Zusammenhang grundsätzlich alle Arten von Geweben, Gewirken, Gestricken, Geflechten, Vliesstoffen umfassen. Gewebe sind einfach zu verarbeiten und zu formen. Die Porosität des Gewebes ermöglicht ein einfaches Durchdringen mit dem Kunststoffmaterial und damit eine gute Integration.

In der Erfindung wird das EMV-wirksame Gewebe in Form eines Prepregs in das Formwerkzeug eingelegt. Bei einem Prepreg handelt es sich um ein elastisches Gewebeteil, das mit einem flüssigen Kunststoffmaterial durchtränkt ist, sodass es in Form gebracht und dann durch Aushärten des Kunststoffmaterials (vorzugsweise mittels Temperatur und/oder Druck) stabilisiert werden kann. Bei dem Kunststoffmaterial handelt es sich bevorzugt um ein Duroplast.

In einer vorteilhaften Ausgestaltung der Erfindung weist die zweite Kunststoffkomponente für das Kunststoff-Formteil des EMV-Abschirmgehäuses ein Thermoplast auf. Diese Ausführungsvariante ist insbesondere bei der Verwendung eines Prepregs von Vorteil, da das Kunststoffmaterial im Prepreg durch den Thermoplast mit ausreichend Temperatur und Druck beaufschlagt wird, dass es aushärten kann. Ein anschließender separater Schritt des Aushärtens kann so entfallen.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, größtenteils schematisch:
- Fig. 1: eine Schnittansicht eines EMV-Abschirmgehäuses gemäß einem Ausführungsbeispiel der vorliegenden Erfindung;
- Fig. 2: eine Schnittansicht zur Erläuterung eines Herstellungsverfahrens eines EMV-Abschirmgehäuses, das nicht Gegenstand der vorliegenden Erfindung ist; und
- Fig. 3: eine Schnittansicht zur Erläuterung des Herstellungsverfahrens zum Integrieren einer Elektronik in ein EMV-Abschirmgehäuse gemäß einer Ausführungsvariante der Erfindung.

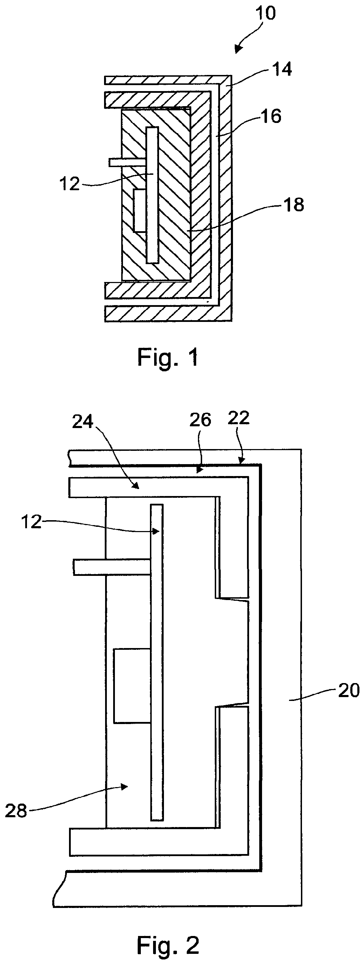

In Figur 1 ist der Grundaufbau eines EMV-Abschirmgehäuses 10 gemäß einem Ausführungsbeispiel der Erfindung dargestellt.

Das EMV-Abschirmgehäuse 10 dient der EMV-wirksamen Abschirmung einer Elektronik 12, die von dem EMV-Abschirmgehäuse 10 zumindest teilweise umschlossen ist. Die Elektronik 12 weist zum Beispiel eine Leiterplatte mit Elektronikkomponenten eines elektronischen Geräts wie beispielsweise eines Elektromotors, Antriebselements, Steuergeräts, etc. auf. Die Elektronik 12 mit dem EMV-Abschirmgehäuse ist zum Beispiel in elektronischen Haushaltsgeräten wie Wäschebehandlungsgeräten, Kochfeldern, Herden, Mikrowellenöfen, Spülmaschinen, und dergleichen einsetzbar.

Das EMV-Abschirmgehäuse 10 weist ein Kunststoff-Formteil 14 aus einer oder mehreren Kunststoffkomponenten auf, das durch ein Spritzgießverfahren geformt worden ist. In diesem Kunststoff-Formteil 14 ist ein EMV-wirksames Gewebe 16 integriert. Die Integration erfolgt beispielsweise durch ein zumindest teilweises Umspritzen des Gewebes 16 durch wenigstens eine Kunststoffkomponente des Kunststoff-Formteils, wie nachfolgend beschrieben.

Erfindungsgemäß ist die Elektronik 12 in einer Vergussmasse 18 gekapselt. Die Vergussmasse 18 ist bevorzugt aus einer Kunststoffkomponente geformt und vorzugsweise wärmeleitend. Die Vergussmasse 18 kann neben der Wärmeableitung und einem mechanischen Schutz der Elektronik 12 auch einer elektrischen Isolierung der Elektronik 12 dienen. Die Elektronik 12 mit der Vergussmasse 18 ist mittels eines gemeinsamen Spitzgießprozesses mit dem Kunststoff-Formteil 14 integriert.

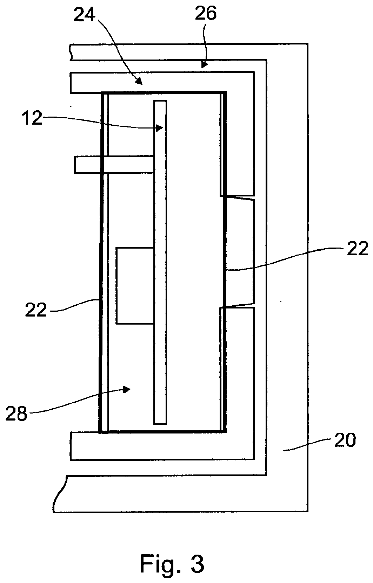

Anhand der Fig. 2 und 3 werden nachfolgend zwei Varianten eines Herstellungsverfahrens für ein derartiges EMV-Abschirmgehäuse näher erläutert. Die EMV-Abschirmwirkung wird dabei mittels eines Verbundspritzgießens bzw. inline im Spritzgießprozess in das Kunststoff-Formteil 14 des EMV-Abschirmgehäuses 10 integriert.

In der Variante von Fig. 2 erfolgt die Integration der Elektronik 12 in das EMV-Abschirmgehäuse 10 in einem einzigen Fertigungsschritt mit mehreren sequenziell oder parallel ausgeführten Spritzgießprozessen in einem Formwerkzeug 20.

Zunächst wird die Elektronik 12 in das Formwerkzeug 20 eingelegt. Dann wird eine Kunststoffkomponente 28 zum Bilden der Vergussmasse 18 eingespritzt. Dann wird das EMV-wirksame Gewebe 16 in Form eines Prepregs 22, d.h. eines mit einem Kunststoffmaterial (z.B. ein Duroplast) durchtränkten Gewebes (z.B. aus Metall-, Kunststoff- und/oder Textilfäden), in das Formwerkzeug eingelegt. Dann wird zunächst eine erste Kunststoffkomponente 24 zum Bilden des Kunststoff-Formteils 14 angrenzend an die Kunststoffkomponente 28 für die Vergussmasse 18 eingespritzt. Die erste Kunststoffkomponente 24 weist vorzugsweise ein wärmeleitendes Kunststoffmaterial auf. Die Kunststoffkomponenten 24 und 28 verschmelzen dabei in ihrem Übergangsbereich miteinander.

Anschließend wird das Prepreg 22 des EMV-wirksamen Gewebes 16 mit einer zweiten Kunststoffkomponente 26 für das Kunststoff-Formteil 14 hinterspritzt. D.h. die zweite Kunststoffkomponente 26 wird zwischen die erste Kunststoffkomponente 24 für das Formteil 14 und das Prepreg 22 eingespritzt und durchdringt dabei auch das Prepreg 22. Die Kunststoffkomponenten 24 und 26 verschmelzen dabei miteinander. Die zweite Kunststoffkomponente 26 weist vorzugsweise ein Elastomer auf, durch dessen Temperatur- und Druckeinwirkung beim Aushärten des Formteils 14 auch das Kunststoffmaterial im Prepreg 22 aushärtet und ein nachgeschalteter Aushärtungsvorgang entfallen kann.

Bei dieser Variante befindet sich das EMV-wirksame Gewebe 16 letztlich im äußeren Bereich des Kunststoff-Formteils 14 des EMV-Abschirmgehäuses 10.

In der erfindungsgemäßen Ausführungsvariante von Fig. 3 erfolgt die Integration der Elektronik 12 in das EMV-Abschirmgehäuse 10 ebenfalls in einem einzigen Fertigungsschritt mit mehreren sequenziell oder parallel ausgeführten Spritzgießprozessen in einem Formwerkzeug 20.

Zunächst werden die Elektronik 12 und das EMV-wirksame Gewebe 16 in Form eines Prepregs 22, d.h. eines mit einem Kunststoffmaterial durchtränkten Gewebes, in das Formwerkzeug 20 eingelegt. Dabei umschließt das Prepreg 22 die Elektronik 12 mit einem bestimmten Abstand zu dieser. Dann wird eine Kunststoffkomponente 28 zum Bilden der Vergussmasse 18 eingespritzt. Diese Kunststoffkomponente 28 ist bevorzugt elektrisch nicht-leitend, sodass sie die Elektronik 12 von dem EMV-wirksamen Gewebe 16 isoliert. Die Kunststoffkomponente 28 für die Vergussmasse 18 durchdringt dabei das Prepreg 22 zumindest teilweise.

Dann wird zunächst eine erste Kunststoffkomponente 24 zum Bilden des Kunststoff-Formteils 14 angrenzend an das Prepreg 22 und die Kunststoffkomponente 28 für die Vergussmasse 18 in das Formwerkzeug 20 eingespritzt. Die Kunststoffkomponente 28 für die Vergussmasse 18 und die erste Kunststoffkomponente 24 für das Formteil 14 weisen jeweils vorzugsweise ein wärmeleitendes Kunststoffmaterial auf.

Anschließend wird eine zweite Kunststoffkomponente 26 für das Formteil 14 angrenzend an die erste Kunststoffkomponente 24 für das Formteil 14 eingespritzt. Die zweite Kunststoffkomponente 26 weist vorzugsweise ein Elastomer auf, durch dessen Temperatur- und Druckeinwirkung beim Aushärten des Formteils 14 auch das Kunststoffmaterial im Prepreg 22 mit aushärtet und ein nachgeschalteter Aushärtungsvorgang entfallen kann.

Bei dieser erfindungsgemäßen Ausführungsvariante befindet sich das EMV-wirksame Gewebe 16 letztlich zwischen der die Elektronik 12 kapselnden Vergussmasse 18 und dem Kunststoff-Formteil 14 des EMV-Abschirmgehäuses 10, wobei die Vergussmasse 18 und das Formteil 14 durch die Spritzgießprozesse miteinander integriert sind.

Die Erfindung wurde Bezugnehmend auf Fig. 1 bis 3 erläutert. Der Fachmann wird problemlos verschiedene Ausführungsvarianten der Erfindung erkennen, die in den durch die anhängenden Ansprüche definierten Schutzbereich fallen.

So ist in der Ausführungsvariante von Fig. 3 das Kunststoff-Formteil 14 aus zwei Kunststoffkomponenten 24, 26 gebildet. Alternativ kann das Formteil 14 auch aus mehr als zwei Kunststoffkomponenten gebildet werden.

Ferner weist in der Ausführungsvariante von Fig. 3 die zweite Kunststoffkomponente 26 für das Formteil 14 ein Elastomer aus, durch dessen Temperatur- und Druckeinwirkung auch das Kunststoffmaterial im Prepreg 22 mit aushärtet. Falls andere Kunststoffmaterialien für die zweite Kunststoffkomponente 26 eingesetzt werden, muss das Kunststoffmaterial im Prepreg 22 möglicherweise in einem separaten Aushärtungsvorgang ausgehärtet werden.

Ferner umschließt das EMV-Abschirmgehäuse 10 die Elektronik 12 in der Ausführungsvariante von Fig. 3 nur teilweise. Alternativ kann das Formteil 14 des EMV-Abschirmgehäuses 10 die Elektronik 12 auch vollständig umschließen. Elektrische Anschlüsse der Elektronik sind dann zum Beispiel durch die Kunststoffkomponenten 24-26 des EMV-Abschirmgehäuses 10 hindurchgeführt.

### BEZUGSZIFFERNLISTE

- 10: EMV-Abschirmgehäuse
- 12: Elektronik
- 14: Kunststoff-Formteil
- 16: EMV-wirksames Gewebe
- 18: Vergussmasse
- 20: Formwerkzeug
- 22: Prepreg für EMV-wirksames Gewebe
- 24: erste Kunststoffkomponente für Formteil
- 26: zweite Kunststoffkomponente für Formteil
- 28: Kunststoffkomponente für Vergussmasse

## Patentansprüche

1. Verfahren zum Herstellen eines EMV-Abschirmgehäuses (10) für eine Elektronik (12), mit den Schritten:
Einlegen der Elektronik (12) in ein Formwerkzeug (20);
Einlegen eines EMV-wirksamen Gewebes (16) in Form eines Prepregs 22, d.h. eines mit einem Kunststoffmaterial durchtränkten Gewebes, in das Formwerkzeug (20) derart, dass das EMV-wirksame Gewebe (16) die Elektronik (12) mit einem Abstand zu dieser umschließt;
Einspritzen einer Kunststoffkomponente (28) zum Bilden einer Vergussmasse (18) zum Kapseln der Elektronik (12) in das Formwerkzeug (20), wobei die Kunststoffkomponente (28) für die Vergussmasse (18) das EMV-wirksame Gewebe (16) zumindest teilweise durchdringt;
Einspritzen einer ersten Kunststoffkomponente (24) zum Bilden eines Kunststoff-Formteils (14) des EMV-Abschirmgehäuses (10) angrenzend an das EMV-wirksame Gewebe (16) und die Kunststoffkomponente (28) für die Vergussmasse (18) in das Formwerkzeug (20); und
Einspritzen einer zweiten Kunststoffkomponente (26) für das Kunststoff-Formteil (14) des EMV-Abschirmgehäuses (10) angrenzend an die erste Kunststoffkomponente (24) für das Kunststoff-Formteil (14) des EMV-Abschirmgehäuses (10) in das Formwerkzeug (20).

2. Verfahren nach Anspruch 1, bei welchem
die Kunststoffkomponente (28) für die Vergussmasse (18) elektrisch nicht-leitend ist.

3. Verfahren nach einem der vorhergehenden Ansprüche, bei welchem die Kunststoffkomponente (28) für die Vergussmasse (18) und die erste Kunststoffkomponente (24) für das Formteil (14) jeweils ein wärmeleitendes Kunststoffmaterial aufweisen.

4. Verfahren nach einem der vorhergehenden Ansprüche, bei welchem die zweite Kunststoffkomponente (26) für das Kunststoff-Formteil (14) des EMV-Abschirmgehäuses (10) ein Thermoplast aufweist.

## Claims

1. Method for producing an EMC shielding housing (10) for a set of electronics (12), comprising the steps of:
placing the electronics (12) in a moulding tool (20), placing an EMC-active woven fabric (16) in the form of a prepreg (22), i.e. a woven fabric impregnated with a plastics material, in the moulding tool (20) in such a way that the EMC-active woven fabric (16) encloses the electronics (12) at a distance therefrom;
injecting a plastics component (28) to form a potting compound (18) for encapsulating the electronics (12) into the moulding tool (20), wherein the plastics component (28) for the potting compound (18) at least partially penetrates the EMC-active woven fabric (16) ;
injecting a first plastics component (24) to form a plastic moulded part (14) of the EMC shielding housing (10) adjacent to the EMC-active woven fabric (16) and the plastics component (28) for the potting compound (18) into the moulding tool (20); and
injecting a second plastics component (26) for the plastic moulded part (14) of the EMC shielding housing (10) adjacent to the first plastics component (24) for the plastic moulded part (14) of the EMC shielding housing (10) into the moulding tool (20).

2. Method according to Claim 1, in which
the plastics component (28) for the potting compound (18) is electrically non-conducting.

3. Method according to one of the preceding claims, in which
the plastics component (28) for the potting compound (18) and the first plastics component (24) for the moulded part (14) each comprise a heat-conducting plastics material.

4. Method according to one of the preceding claims, in which
the second plastics component (26) for the plastic moulded part (14) of the EMC shielding housing (10) comprises a thermoplastic.

## Revendications

1. Procédé de fabrication d'un boîtier de blindage CEM (10) destiné à une électronique (12), le procédé comprenant les étapes suivantes :
placer l'électronique (12) dans un outil de moulage (20) ;
insérer un tissu CEM-efficace (16) se présentant sous la forme d'un préimprégné (22), c'est-à-dire un tissu imprégné d'une matière synthétique, dans l'outil de moulage (20) de telle manière que le tissu CEM-efficace (16) enferme l'électronique (12) à distance de celle-ci ;
injecter un composant de matière synthétique (28) pour former un composé d'enrobage (18) destiné à encapsuler l'électronique (12) dans l'outil de moulage (20), le composant de matière synthétique (28) destiné au composé d'enrobage (18) pénétrant au moins partiellement dans le tissu CEM-efficace (16) ;
injecter un premier composant de matière synthétique (24), destiné à former une partie moulée (14) en matière synthétique du boîtier de CEM-blindage (10) de manière adjacente au tissu CEM-efficace (16), et le composant de matière synthétique (28) destiné au composé d'enrobage (18) dans l'outil de moulage (20) ; et
injecter un deuxième composant de matière synthétique (26) destiné à la partie moulée (14) en matière synthétique du boîtier de CEM-blindage (10) dans l'outil de moulage (20) de manière adjacente au premier composant de matière synthétique (24) destiné à la partie moulée (14) en matière synthétique du boîtier de CEM-blindage (10).

2. Procédé selon la revendication 1, dans lequel
le composant de matière synthétique (28) destiné au composé d'enrobage (18) est électriquement non conducteur.

3. Procédé selon l'une des revendications précédentes, dans lequel
le composant de matière synthétique (28) destiné au composé d'enrobage (18) et le premier composant de matière synthétique (24) destiné à la pièce moulée (14) comportent chacun une matière synthétique thermoconductrice.

4. Procédé selon l'une des revendications précédentes, dans lequel
le deuxième composant de matière synthétique (26) destiné à la partie moulée (14) en matière synthétique du boîtier de CEM-blindage (10) comprend une matière thermoplastique.
